# EUROPÄISCHE PATENTSCHRIFT

(11) **EP 1 223 679 B1**
(45) Veröffentlichungstag und Bekanntmachung des Hinweises auf die Patenterteilung: **27.10.2004**
(21) Anmeldenummer: 01113739.5
(22) Anmeldetag: 05.06.2001
(51) Int. Cl.: H03M 13/41

(54) **Berechnung und Zuweisung von Übergangsmetrikwerten für einen Viterbi-Dekodierer**
Calculation and allocation of transition metrics for Viterbi decoder
Calcul et allocation de métriques de transitions pour décodeur de Viterbi

(30) Priorität: 21.12.2000 DE 10064102
(43) Veröffentlichungstag der Anmeldung: 17.07.2002
(73) Patentinhaber: Infineon Technologies AG, 81669 München (DE)
(72) Erfinder: Becker, Burkhard, 85737 Ismaning (DE)
(74) Vertreter: Lange, Thomas, Dr.

(56) Entgegenhaltungen:
- EP-A- 0 409 205
- US-A- 5 432 803
- US-A- 5 881 075
- SOHI N.; GULAK P.: 'A MULTI-STANDARD SET-TOP BOX CHANNEL DECODER' 2000 IEEE WORKSHOP ON SIGNAL PROCESSING SYSTEMS (SIPS 2000) 11 Oktober 2000 - 13 Oktober 2000, LAFAYETTE (LA) (US), Seiten 295 - 304

## Beschreibung

Die Erfindung betrifft eine Einheit zur Berechnung von Übergangsmetrikwerten für einen Viterbi-Dekodierer, der insbesondere in Mobilfunkempfängern zur Dekodierung von kanalkodierten Mobilfunksignalen einsetzbar ist. Ferner betrifft die Erfindung eine Schaltungsanordnung, welche ein Hardware-Rechenwerk zur Berechnung von Übergangsmetrikwerten, eine Einheit zur Durchführung von ACS-Operationen, und eine Steuereinheit zur Steuerung der Übergabe von berechneten Übergangsmetrikwerten an die Einheit zur Durchführung von ACS-Operationen umfasst, sowie ein Verfahren zur Übergabe von berechneten Übergangsmetrikwerten zwischen den genannten Einheiten.

In Mobilfunksystemen wird das auszusendende Signal zur Anpassung an den Mobilfunkkanal senderseitig einer Kanalkodierung unterzogen. Bei der Kanalkodierung wird der zu übertragenden Datensequenz Redundanz hinzugefügt, um die Übertragungssicherheit zu erhöhen. Bei der Übertragung des kanalkodierten Mobilfunksignals wird dieses vom zeitvarianten Mobilfunkkanal verzerrt und von Rauschen überlagert. Die Aufgabe des Empfängers besteht nun darin, anhand der empfangenen Datensequenz aus sämtlichen möglichen gesendeten Datensequenzen diejenige herauszufinden, welche mit größtmöglicher Wahrscheinlichkeit der tatsächlich gesendeten Datensequenz entspricht. Neben einer Entzerrung des empfangenen Signals muß hierfür eine Kanaldekodierung durchgeführt werden.

In den meisten bekannten digitalen Mobilfunkempfängern wird für die Kanaldekodierung ein Viterbi-Dekodierer verwendet. Dieser beruht auf der Abarbeitung des bekannten Viterbi-Algorithmus (VA), mittels welchem auf rekursive Weise der kürzeste Pfad durch ein Zustands-Diagramm bestimmt wird, welches die Dekodiervorschrift widerspiegelt und als Trellis-Diagramm bezeichnet wird. Die Bestimmung dieses kürzesten Pfads durch das Trellis-Diagramm ist gleichbedeutend mit der Rekonstruktion der Datensequenz, welche senderseitig dem Kanalkodierer zugeführt wurde.

Die einfachste Realisierung eines Viterbi-Dekodierers besteht darin, die Abarbeitung des VA von einem Prozessor auf der Basis eines Mikro-Computerprogramms (Firmware) durchzuführen. Diese Vorgehensweise erfordert besonders bei hohen Datenbitraten und einer großen Rückgrifftiefe der bei der Kanalkodierung verwendeten Faltungspolynome einen digitalen Signalprozessor (DSP) mit hoher Rechenleistung. Aufgrund der Kosten aber vor allem auch wegen des hohen Energieverbrauchs sind DSPs mit hohen Rechenleistungen in Mobilstationen praktisch nicht einsetzbar. Deswegen ist für das Prozessieren des VA eine Hardware-Unterstützung erforderlich.

Die Abarbeitung des VA umfaßt pro Zeitschritt im wesentlichen drei Rechenabläufe: Die Berechnung der Übergangsmetrikwerte im Trellis-Diagramm, die Durchführung der ACS-(Add-Compare-Select-)Operationen, und die Trace-Back-Operation zur Ermittlung eines zeitlich zurückliegenden Datenbits. Unter diesen Rechenabläufen ist die ACS-Operation diejenige mit dem höchsten Rechenaufwand.

Es ist bereits bekannt, eine Hardware-Unterstützung zur Durchführung der ACS-Operation zu realisieren. Ein Hardware-Rechenwerk zur Durchführung der ACS-Operation ist beispielsweise in der internationalen Anmeldung WO 01/11842 beschrieben. Eine weitere Hardware-Struktur zur Durchführung einer ACS-Operation für einen Kanaldekodierer ist der US-Patentschrift 5,530,707 zu entnehmen.

Die Berechnung der Übergangsmetrikwerte wird üblicherweise in dem DSP durchgeführt. Der Grund hierfür ist vor allem darin zu sehen, dass die Berechnung der Übergangsmetrikwerte abhängig von dem Standard des betrachteten Mobilfunksystems und auch abhängig von der verwendeten Koderate R = 1/k der Kanalkodierung ist, was durch eine Software-basierte Berechnung der Überrgangsmetrikwerte in einfacher Weise berücksichtigt werden kann. Nachteilig bei dieser Lösung ist jedoch einerseits die (energieverbrauchende) Rechenbelastung des DSP und andererseits die erforderliche hohe Bandbreite, welche für den Datenaustausch zwischen dem DSP und der ACS-Einheit benötigt wird.

In der Schrift US 5,432,803 ist eine Schaltung zur Berechnung von Übergangsmetrikwerten beschrieben, bei welcher durch Aufsummieren der empfangenen Bitwerte oder der invertierten Bitwerte über n Code-Bits eines für einen Trellis-Übergang charakteristischen Code-Wortes vier Übergangsmetrikwerte abgeleitet werden. Die Berechnung erfolgt sequentiell in Bezug auf unterschiedliche Trellis-Zustände.

In der Schrift US 5,881,075 ist als nächstliegender Stand der Technik ein Viterbi-Decodierer beschrieben, in welchem eine Zuordnung von vorausberechneten Übergangsmetrikwerten für die ACS-Operationen durch eine Zuweisungseinheit durchgeführt wird. Die Zuweisungseinheit enthält einen Zähler, welcher durch die Trellis-Zustände durch zählt und unter Verwendung des Zählerstands jeweils einen Wert für drei Kontrollsignale in Abhängigkeit des Codepolynoms berechnet und damit ein Auswahlmittel ansteuert, welches für jede ACS-Operation jeweils zwei von insgesamt acht berechneten Übergangsmetrikwerte bestimmt.

In der Veröffentlichungsschrift "A Multi-Standard Set-Top Box Channel Decoder" von N. Sohi und G. Gulak, 2000 IEEE workshop on signal processing systems (SIPS 2000), Lafayette, Seiten 295 bis 304, ist eine parallel ausgelegte Einheit zur Berechnung von Übergangsmetrikwerten für einen Viterbi-Decodierer beschrieben, welche für mehrere Standards eingesetzt werden kann, wobei die Übergangsmetrikwerte als Summe einer variablen Anzahl von Summanden berechnet werden. Durch diese Maßnahme werden zwei unterschiedliche Coderaten unterstützt, die in den Übertragungsstandards DAB (Digital Audio Broadcasting) und DVB (Digital Video Broadcasting). verwendet werden.

Aus der Schrift EP 0 409 205 A2 ist ein Hardware-Rechenwerk zur Bestimmung von Übergangsmetriken für einen Viterbi-Dekodierer bekannt, welches eingangsseitig einen Satz von 2 Soft-Input-Werten G1 und G2 bei einer Koderate von 1/2 entgegennimmt und in paralleler Weise Übergangsmetrikwerte der Form i1·G1+i2·G2 (i1, i2 = ±1) berechnet und ausgibt.

Der Erfindung liegt die Aufgabe zugrunde, eine Schaltungsanordnung anzugeben, welche eine Hardware-Rechenwerk zur Berechnung von Übergangsmetrikwerten für einen Viterbi-Dekodierer umfasst, wobei das Hardware-Rechenwerk eine resourcensparende Berechnung der Übergangsmetrikwerte in einem Viterbi-Dekodierer ermöglicht. Dabei soll das Hardware-Rechenwerk auch die Berechnung von Übergangsmetrikwerten für unterschiedliche Standards gestatten und in der Schaltungsanordnung sollen die in dem Hardware-Rechenwerk berechneten Übergangsmetrikwerten an eine in der Schaltungsanordnung enthaltene Einheit zur Durchführung von ACS-Operationen ermöglichen.

Die der Erfindung zugrundeliegende Aufgabenstellung wird durch die Merkmale des Anspruchs 1 gelöst.

Eine Schaltungsanordnung umfasst ein Hardware-Rechenwerk zur Berechnung von Übergangsmetrikwerten, eine Einheit zur Durchführung von ACS-Operationen, und ein Steuermittel zur Steuerung des Zugriffs der Einheit zur Durchführung von ACS-Operationen auf die von dem Hardware-Rechenwerk berechneten Übergangsmetrikwerte.

Durch die Verwendung eines Hardware-Rechenwerks wird eine resourcensparende Berechnung der Übergangsmetrikwerte erreicht, es erübrigt sich infolgedessen die Berechnung der Übergangsmetrikwerte durch einen DSP mittels Firmware.

Erfindungsgemäß ist das Hardware-Rechenwerk dazu ausgelegt, einen Satz von n Soft-Input-Werten s1,..,sn entgegenzunehmen und daraufhin Übergangsmetrikwerte der Form i1·s1+..+in·sn auszugeben, wobei n eine variable ganze Zahl mit n ≥ 2 ist und i1,..,in jeweils die Werte ±1 annehmen kann. Infolge der Variabilität von n kann das Hardware-Rechenwerk Übergangsmetrikwerte für unterschiedliche Mobilfunkstandards bzw. Koderaten berechnen.

Erfindungsgemäß ist das Steuermittel ausgelegt, den Zugriff der Einheit zur Durchführung von ACS-Operationen gemäß einer Code-abhängigen Referenztabelle zu steuern, welche den Zustandsübergängen im Trellis-Diagramm die im Hardware-Rechenwerk berechneten Übergangsmetrikwerte zuweist. Durch die Referenztabelle wird gewährleistet, dass die Einheit zur Durchführung von ACS-Operationen, bei der es sich vorzugsweise um ein weiteres Hardware-Rechenwerk handelt, für jeden Zustandsübergang den richtigen Übergangsmetrikwert verwendet.

Durch das erfindungsgemäße Vorsehen der Schaltungsanordnung für die Verwendung mehrerer unterschiedlicher Referenztabellen kann die Datenübergabe zwischen dem Hardware-Rechenwerk zur Berechnung von Übergangsmetrikwerten und der Einheit zur Durchführung von ACS-Operationen standardübergreifend und für unterschiedliche Faltungspolynome automatisiert werden.

In diesem Zusammenhang wird darauf hingewiesen, dass in sämtlichen bekannten Mobilfunkstandards wie GSM (Global System for Mobile Communications), EDGE (Enhanced Data Services for GSM Evolution), UMTS (Universal Mobile Telecommunications System), IS-136 (D-AMPS) Faltungspolynome mit einer Koderate von R = 1/2, 1/3, 1/4, 1/5, 1/6 verwendet werden (d.h. k = 2, 3, 4, 5, 6). Hinzu kommt, dass sämtliche erwähnten Standards maximal vier voneinander unabhängige Faltungspolynome (Generator-Polynome) einsetzen. Da die Anzahl der pro Zeitschritt im Trellis-Diagramm auftretenden unterschiedlichen Übergangsmetrikwerte 2^{p} beträgt, wobei p = max{k,4} ist, ergeben sich für R = 1/2 vier unterschiedliche Übergangsmetrikwerte, für R = 1/3 acht unterschiedliche Übergangsmetrikwerte und für R = 1/4, 1/5, 1/6 eine Anzahl von 16 unterschiedlichen Übergangsmetrikwerten. Somit ermöglicht eine erste bevorzugte Schaltungsanordnung mit einem Hardware-Rechenwerk, dessen Variablität von n sich auf die Werte 2, 3 erstreckt, die Kanaldekodierung von mit einer Koderate R = 1/2 und 1/3 kanalkodierten Signalen, und ein zweite Schaltungsanordnung mit einem Hardware-Rechenwerk, dessen Variabilität von n sich auf die Werte 2, 3, 4, erstreckt, ermöglicht eine Dekodierung von mit sämtlichen der genannten Koderaten kanalkodierten Signalen.

Vorzugsweise umfaßt die erfindungsgemäße Schaltungsanordnung bezüglich des Hardware-Rechenwerks eine Mehrzahl von parallel angeordneten Addierern sowie Negierern, wobei jeder Addierer nmax Eingänge aufweist, und wobei nmax der maximale Wert ist, welchen n annehmen kann. In diesem Fall kennzeichnet sich eine vorteilhafte Ausführungsvariante der Erfindung dadurch, dass das Rechenwerk 2^{nmax-1} Addierer umfaßt, wobei jedem Ausgang eines Addierers ein erster Negierer nachgeschaltet ist. Auf diese Weise können von den 2^{nmax} maximal berechenbaren Übergangsmetrikwerten die erste Hälfte davon an den Ausgängen der Addierer und die zweite Hälfte davon an den Ausgängen der ersten Negierer abgegriffen werden. Für den Fall nmax = 3 werden bei dieser bevorzugten Realisierung der Schaltungsanordnung bezüglich des Rechenwerks demnach vier Addierer mit jeweils drei Eingängen benötigt, für den Fall nmax = 4 sind demnach acht Addierer mit jeweils vier Eingängen vorzusehen.

Vorzugsweise ist die Referenztabelle so gestaltet, dass sie allen Zustandsübergängen innerhalb eines Butterflies im Trellis-Diagrammm genau einen Übergangsmetrikwert zuweist. In diesem Fall muss zur Ausführung der ACS-Operationen bezüglich eines Butterflies nur ein einziger Übergangsmetrikwert von dem Hardware-Rechenwerk zur Berechnung der Übergangsmetrikwerte zu der Einheit zur Durchführung von ACS-Operationen übergeben werden, wobei unterschiedliche Vorzeichen der Übergangsmetrikwerte für Zustandsübergänge innerhalb eines Butterflies von der Einheit zur Durchführung von ACS-Operationen berücksichtigt werden.

Die Erfindung wird nachfolgend anhand von Ausführungsbeispielen unter Bezugnahme auf die Zeichnung beschrieben; in dieser zeigt:
- Fig. 1: eine schematische Blockschaltbilddarstellung eines Viterbi-Dekodierers;
- Fig. 2: einen Ausschnitt aus einem Trellis-Diagramm für zwei Zeitschritte;
- Fig. 3: ein Schaltbild eines ersten Ausführungsbeispiels eines Hardware-Rechenwerks zur Berechnung von Übergangsmetrikwerten;
- Fig. 4: ein Schaltbild eines zweiten Ausführungsbeispiels eines Hardware-Rechenwerks zur Berechnung von Übergangsmetrikwerten;
- Fig. 5: eine Darstellung einer Referenztabelle für den EDGE-Standard bezogen auf das erste Ausführungsbeispiel; und
- Fig. 6: eine schematische Blockschaltbilddarstellung einer erfindungsgemäßen Schaltungsanordnung aus Hardware-Rechenwerk zur Berechnung von Übergangsmetrikwerten, ACS-Rechenwerk und Steuereinheit.

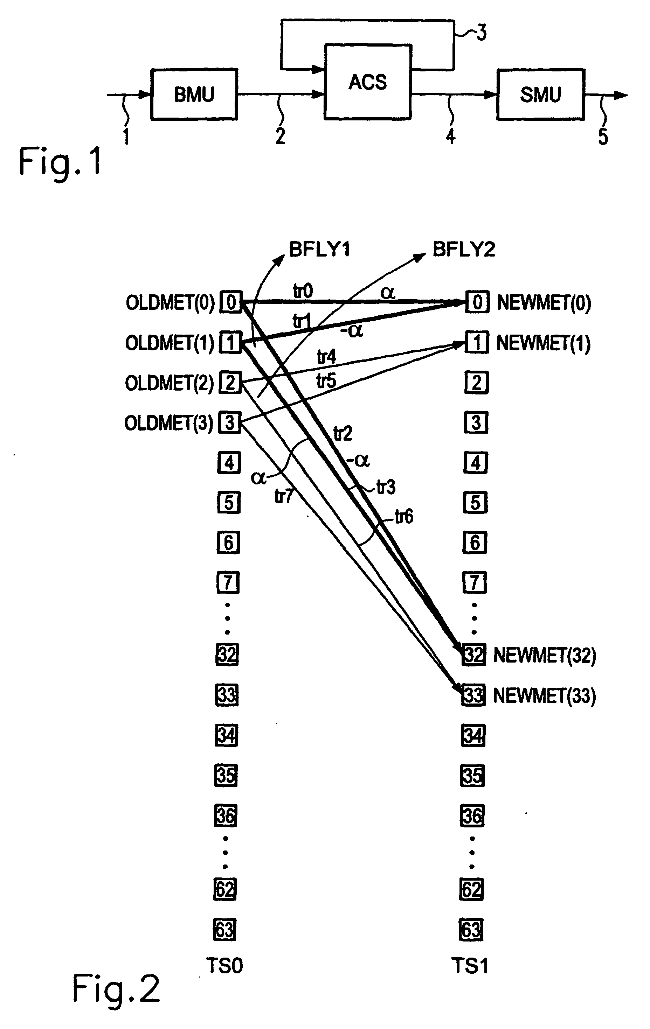

Fig. 1 zeigt den generellen Aufbau eines Viterbi-Dekodierers, bestehend aus einer Einheit zur Berechnung von Übergangsmetrikwerten BMU (Branch Metric Unit), einer Einheit zur Durchführung von ACS-Operationen, ACS, und einer Einheit zur Speicherung der ermittelten Pfade SMU (Survivor Memory Unit).

Im folgenden wird von einer senderseitigen Faltungskodierung mit der Rückgrifftiefe L (entspricht einem Schieberegister mit L-1 Speicherzellen) und einer Koderate R = 1/k ausgegangen. Der Zustand des Kodierers kann zu jedem Zeitschritt durch die Belegung seines Schieberegisters ausgedrückt werden, d.h. es existieren 2^{L-1} Kodiererzustände. Die Koderate R = 1/k stellt ein Maß für die beim Kodiervorgang in den ursprünglichen Datenbitstrom eingebrachte Redundanz dar und besagt, dass der (senderseitige) Kodierer für ein erhaltenes Datenbit k Datenbits ausgibt. Der Begriff Zeitschritt bezieht sich auf die Bitsequenz des ursprünglichen, noch nicht kodierten Datenbitstroms.

Die Einheit zur Berechnung von Übergangsmetrikwerten BMU nimmt über eine Datenverbindung 1 einen Datenstrom entgegen, welcher aus Soft-Input-Werten besteht, die von einem (nicht dargestellten) vorgeordneten Entzerrer erzeugt wurden. Pro Zeitschritt liegen k Soft-Input-Werte vor, wobei jeder Soft-Input-Wert die Wahrscheinlichkeit für das Auftreten einer 1 oder einer 0 eines detektierten Datenbits im kodierten Empfangssignal angibt.

Die Einheit BMU zur Berechnung der Übergangsmetrikwerte berechnet nun für jeden Übergang im Trellis-Diagramm eine Übergangsmetrik, welche ein Maß für die Wahrscheinlichkeit dieses Zustandsübergangs unter Berücksichtigung,der erhaltenen Soft-Input-Werte ist. Die von der Einheit BMU berechneten Übergangsmetrikwerte werden der ACS-Einheit über eine Datenverbindung 2 zugeleitet. Zur Erläuterung des Rechenablaufs der ACS-Einheit wird auf den in Fig. 2 dargestellten Ausschnitt eines Trellis-Diagramms bezüglich zweier Zeitschritte TS0 und TS1 Bezug genommen. In Fig. 2 ist ein aus 64 Zuständen aufgebautes Trellis-Diagramm dargestellt, wie es beispielsweise beim EDGE-Standard mit L = 7 auftritt. In jedem Zeitschritt kann der Kodierer somit einen von 64 möglichen Kodiererzuständen einnehmen. Die 64 möglichen Zustände des senderseitigen Kodierers sind in Fig. 2 in Form von durchnumerierten Kästchen über den Zeitschritten TS0 und TS1 dargestellt. Die Nummern der Zustände laufen von 0 bis 63. Im GSM-Standard sind z.B. 16 verschiedene Zustände (L = 5) des Kodierers möglich.

Die ACS-Operationen bezüglich des Zeitschritts TS0 seien bereits durchgeführt. Für jeden der 64 Zustände im Zeitschritt TS0 ist dann bereits ein Metrikwert berechnet worden. Ferner steht der zu jedem dieser Zustände führende Pfad (Sequenz von Vorgänger-Zuständen) fest. Der für den Zustand i, i = 0,..,63 im Zeitschritt TS0 berechnete Metrikwert wird im folgenden mit OLDMET(i) bezeichnet.

Die Aufgabe der ACS-Operation besteht darin, für jeden Zielzustand im Zeitschritt TS1 einen neuen Metrikwert zu berechnen. Die für die Zustände im Zeitschritt TS1 berechneten neuen Metrikwerte werden mit NEWMET(i), i = 0,..,63 bezeichnet.

Die Berechnung der neuen Metrikwerte für den Zeitschritt TS1 wird folgendermaßen durchgeführt:

Betrachtet wird zunächst der Zielzustand 0. Je nach dem Wert des Eingabebits bei der senderseitigen Kodierung (welcher unbekannt ist) wird der Zustand 0 im Zeitschritt TS1 entweder von dem Zustand 0 oder von dem Zustand 1 zum Zeitschritt TS0 erreicht. Um den wahrscheinlicheren dieser beiden Vorgänger-Zustände und damit den wahrscheinlicheren der beiden möglichen Übergänge zu entscheiden, werden die Summen OLDMET(0)+α und OLDMET(1)-α gebildet. Dabei bezeichnet α den zu dem Übergang tr0 von dem Vorgänger-Zustand 0 zu dem Zielzustand 0 gehörenden Übergangsmetrikwert, und -α bezeichnet den zu dem Übergang tr1 von dem Vorgänger-Zustand 1 zu dem Zielzustand 0 gehörenden Übergangsmetrikwert. Diese beiden Übergangsmetrikwerte unterscheiden sich lediglich im Vorzeichnen. Die Addition eines alten Metrikwerts OLDMET mit einem Übergangsmetrikwert α bzw. -α wird als "ADD"-Operation bezeichnet.

Der größere der beiden Summenwerte wird ermittelt ("COMPARE"-Operation) und wird der neue Metrikwert des Zustands 0 im Zeitschritt TS1, d.h. NEWMET(0)=Max{OLDMET(0)+α;OLDMET(1)-α}. Der zugehörige Übergang wird als wahrscheinlicherer der beiden möglichen Übergänge ausgewählt ("SELECT"-Operation). Auf diese Weise wird für jeden Zustand im Zeitschritt TS1 der wahrscheinlichere Übergang sowie der wahrscheinlichere Vorgänger-Zustand bestimmt.

Die Durchführung der ACS-Operationen für einen Zeitschritt erfolgt auf der Basis von sogenannten "Butterflies". Ein Butterfly zu den Vorgänger-Zuständen 0 und 1 ist in Fig. 2 mit BFLY1 bezeichnet und umfaßt neben den gerade erwähnten Übergängen tr0, tr1 in den Zielzustand 0 auch die beiden anderen möglichen Übergänge tr2 und tr3 aus den Vorgänger-Zuständen 0 und 1 in den Zeitschritt TS1. Diese Übergänge führen beim EDGE-Standard in den Zustand 32 (beim GSM-Standard mit L = 5 in den Zustand 8) des Zeitschrittes TS1. Dabei weisen die Übergänge tr2 und tr3 die gleichen Übergangsmetrikwerte, nämlich -α und α, wie die Übergänge tr1 bzw. tr0 auf. Die Durchführung der ACS-Operationen nach dem Butterfly-Schema in Vorwärtsrichtung hat den Vorteil, dass der Aufruf von nur zwei Übergangsmetrikwerten α und -α (oder in bevorzugter Weise der Aufruf nur eines Übergangsmetrikwerts mit nachfolgender Negierung desselben in der ACS-Einheit) die vollständige Ausführung der ACS-Operationen für zwei Zielzustände (d.h. ein Butterfly) ermöglicht.

In einem nächsten Zyklus werden, wie in Fig. 2 dargestellt, die nächsten alten Metrikwerte OLDMET(2) und OLDMET(3) aus einem Speicher ausgelesen und die zugehörigen neuen Metrikwerte NEWMET(1) und NEWMET(33) für den Butterfly BFLY2 in entsprechender Weise berechnet (Übergänge tr4, tr5, tr6, tr7, dargestellt durch dünne Linien). Die Schleife 3 in Fig. 1 verdeutlicht, dass das in Fig. 2 dargestellte Trellis-Diagramm in jedem Zeitschritt Butterfly für Butterfly abgearbeitet wird, bis sämtliche neuen Metriken NEWMET(i), i = 0,..,63, berechnet sind.

Nachdem für den Zeitschritt TS1 sämtliche Metrikwerte bestimmt sind und die zugehörigen Übergänge der Einheit SMU über die Datenverbindung 4 mitgeteilt wurden, führt die Einheit SMU eine Trace-Back-Operation zur Ermittlung eines um eine bestimmte Anzahl von Zeitschritten zurückliegenden Datenbits durch. Der Trace-Back-Operation liegt zugrunde, dass länger zurückliegende Übergangs-Datenbits eine höhere Sicherheit aufweisen als diejenigen Übergangs-Datenbits, die im aktuellen Zeitschritt bestimmt wurden. Im Trellis-Diagramm zeigt sich dies daran, dass die einzelnen Pfade in zeitlicher Rückwärtsrichtung konvergieren und ab einer gewissen zeitlichen Rückgriffslänge übereinstimmen.

An einem Ausgang 5 der Einheit SMU werden die dekodierten Datenbits ausgegeben.

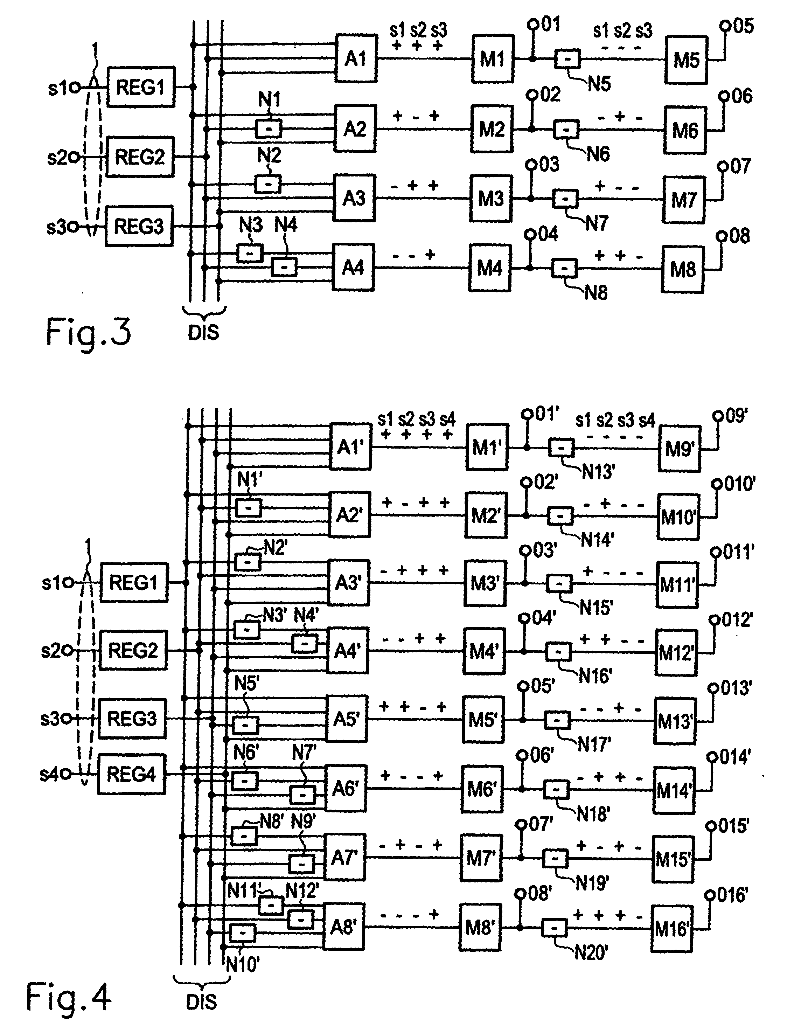

Fig. 3 zeigt ein erstes Ausführungsbeispiel einer erfindungsgemäßen Einheit zur Berechnung von Übergangsmetrikwerten. Die Einheit ist in Form eines Hardware-Rechenwerks RW1, d.h. als einfacher digitaler Rechenschaltkreis realisiert, welcher drei Eingabespeicher REG1, REG2, REG3, einen Signalverteiler DIS, acht Negierer (Zweierkomplement-Einheiten) N1, N1, .., N8, vier Addierer A1, A2, .., A4 mit jeweils drei Addierereingängen und acht Ausgabespeicher M1, M2, .., M8 aufweist. Jedem Ausgabespeicher M1, M2, .., M8 ist ein Ausgang O1, O2, .., O8 zugeordnet. Die Eingabespeicher REG1, REG2, REG3 nehmen jeweils einen vorzeichenbehafteten Soft-Input-Wert s1, s2 bzw. s3 entgegen und können hierfür eine Speichergröße von jeweils acht Bit (eines davon ein Vorzeichenbit) aufweisen. Der Signalverteiler DIS verbindet jeden Addierer A1-4 mit sämtlichen drei Eingabespeichern REG1-3, wobei gemäß Fig. 3 in einige der Verbindungswege die Negierer N1-4 eingesetzt sind. Die Schaltung ist so konzipiert, dass beim Addierer A1 kein Eingang negiert wird, beim Addierer A2 der mit dem zweiten Eingabespeicher REG2 verbundene Eingang negiert wird, beim Addierer A3 der mit dem ersten Eingabespeicher REG1 verbundene Eingang negiert wird und beim vierten Addierer A4 die mit dem Eingabespeicher REG1 und REG2 gekoppelten Eingänge negiert werden.

Die von den Addierern A1-4 ausgegebenen Summen werden den Ausgabespeichern M1-4 zugeführt. Diese wiederum sind jeweils über die weiteren Negierer N5-8 mit den Eingängen der Ausgabespeicher M5-8 verbunden.

Die Ausgabespeicher M1-8 können jeweils als Doppel-Register ausgeführt sein, wodurch ein wechselweiser Zugriff auf die einzelnen Register jedes Ausgabespeichers M1-8 beim Schreiben und Lesen erfolgen kann.

Im folgenden wird die Arbeitsweise des Rechenwerks RW1 näher erläutert.

Im Falle einer Koderate R = 1/3 liegen für jeden Zeitschritt drei Soft-Input-Werte s1, s2, s3 vor. Diese drei Werte für einen Zeitschritt werden wie bereits erwähnt in einem Entzerrer berechnet und dem Rechenwerk RW1 üblicherweise von einem DSP (nicht dargestellt) zur Verfügung gestellt, welcher über eine Schnittstelle bei 1 mit dem Rechenwerk RW1 gekoppelt ist. Dabei wird s1 in dem ersten Eingabespeicher REG1, s2 in dem zweiten Eingabespeicher REG2 und s3 in dem dritten Eingabespeicher REG3 abgelegt. Am Ausgang des ersten Addierers A1 ergibt sich die Summe s1+s2+s3, die Ausgänge der zweiten, dritten und vierten Addierer A2, A3, A4 stellen die Werte s1-s2+s3 bzw. -s1+s2+s3 bzw. -s1-s2+s3 zur Verfügung. Die genannten Werte werden dann z.B. als Zehn-Bit-Worte in den Ausgabespeichern M1-4 abgelegt. In den Ausgabespeichern M5-8 werden die negierten Summenwerte -s1-s2-s3, -s1+s2-s3, s1-s2-s3 bzw. s1+s2-s3 gespeichert. Somit repräsentieren die in den Ausgabespeichern M1-8 abgespeicherten Summenwerte sämtliche ± Kombinationsmöglichkeiten der Soft-Input-Werte s1, s2 und s3. Diese acht Summenwerte sind die acht möglichen Übergangsmetrikwerte zu dem betrachteten Zeitschritt. Sie müssen für jeden Zeitschritt neu berechnet werden.

Es wird deutlich, dass eine funktionell identische Schaltung auch mit anderen Bauelementen realisierbar ist. Beispielsweise können statt der Addierer mit drei Eingängen jeweils zwei Addierer mit zwei Eingängen eingesetzt werden. Eine andere Abwandlungsmöglichkeit besteht darin, dass im Signalweg hinter den Ausgabespeichern M1-4 eine sequentielle Negierung der ersten vier errechneten Übergangsmetrikwerte durchgeführt wird.

Bei einer Koderate von R = 1/2 kann die gleiche Hardware verwendet werden, der einzige Unterschied besteht darin, dass s3 = 0 gesetzt wird. Es werden dann lediglich vier Übergangsmetrikwerte aus den zwei Soft-Input-Werten s1 und s2 berechnet. Die Übergangsmetrikwerte können an vier geeigneten Ausgängen (z.B. O1-4) abgegriffen werden.

Bei kleineren Koderaten von 1/4, 1/5, 1/6 und einer Verwendung von lediglich drei unabhängigen Faltungspolynomen kann der DSP vorab eine Kombination von äquivalenten Soft-Input-Werten vornehmen (d.h. Soft-Input-Werte, denen das gleiche Generator-Polynom zugrunde liegt, werden zusammengefasst), so dass auch in diesem Fall für jeden Zeitschritt nur drei Soft-Input-Werte s1, s2, s3 für das Rechenwerk RW1 bereitstehen. Da für sämtliche Kodierverfahren bei GSM und EDGE maximal acht verschiedene Übergangsmetrikwerte für einen Zeitschritt möglich sind, ist das in Fig. 3 dargestellte Rechenwerk RW1 für diese Standards universell einsetzbar. Dies gilt auch für unterschiedliche Rückgrifftiefen der Kodierung.

Fig. 4 zeigt ein zweites Ausführungsbeispiels eines erfindungsgemäßen Hardware-Rechenwerks RW2. Das Rechenwerk RW2 gemäß zweitem Ausführungsbeispiel ist strukturell mit dem Rechenwerk RW1 vergleichbar und unterscheidet sich von diesem im wesentlichen nur dadurch, dass vier Eingabespeicher REG1-4 zur Entgegennahme von insgesamt vier Soft-Input-Werten s1, s2, s3, s4 vorgesehen sind. Ferner umfaßt das Rechenwerk einen Signalverteiler DIS' für jeweils vier Signale, acht Addierer A1', .., A8' mit jeweils vier Eingängen, 16 Ausgabespeicher M1', .., M16', insgesamt 20 Negierer N1', .., N20' sowie 16 Ausgänge O1', .., O16', welche den entsprechenden Ausgabespeichern M1', .., M16' zugeordnet sind.

In Analogie zur vorhergehenden Beschreibung des Rechenwerks RW1 stellen die acht Addierer A1-8' die Übergangsmetrikwerte s1+s2+s3+s4, +sl-s2+s3+s4, -sl+s2+s3+s4, -s1-s2+s3+s4, +s1+s2-s3+s4, +s1-s2-s3+s4, -s1+s2-s3+s4 bzw. -s1-s2-s3+s4 bereit, und die restlichen Übergangsmetrikwerte werden wiederum durch Negierung dieser Übergangsmetrikwerte mittels der Negierer N13'-20' berechnet.

Das Rechenwerk RW2 ist insofern Standard-unspezifisch, als die Signalaufteilung und Negierung der Addierereingänge so vorgenommen wird, dass durch Setzen von s3 = 0 und s4 = 0 das Rechenwerk RW2 z.B. an den Ausgängen O1'-4' (oder Ausgänge O1', 02', O9', O10') vier Ausgangsmetrikwerte für k = 2 liefert, und dass durch Setzen von s4 = 0 z.B. die Ausgänge O1'-8' acht Ausgangsmetrikwerte für k = 3 liefern. Da auch bei UMTS in keinem Fall mehr als 16 Übergangsmetrikwerte berechnet werden müssen, ist das Rechenwerk RW2 standardübergreifend für sämtliche bekannte Viterbi-Dekodierer einsetzbar.

Die Ausführungen zum Rechenwerk RW1 in Bezug auf Modifikationen und alternative Realisierungsformen sind auf das Rechenwerk RW2 analog übertragbar. Auch dieses Rechenwerk RW2 kann durch Kombination weiterer Soft-Input-Werte zur Kanaldekodierung für die Fälle k = 5 oder k = 6 eingesetzt werden.

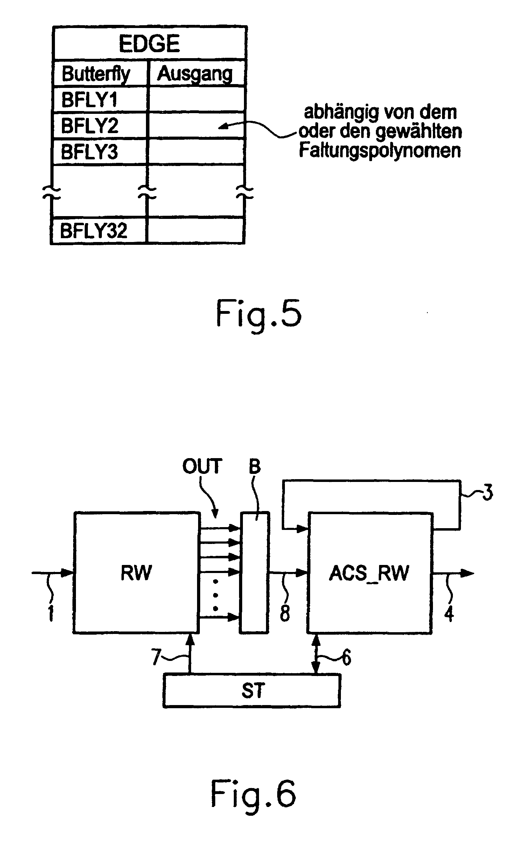

Bei einer ACS-Einheit, welche ebenfalls in Form eines Hardware-Rechenwerks ausgeführt ist, ist es für die Abarbeitung der Butterflies erforderlich, dass dem ACS-Rechenwerk stets die richtigen Übergangsmetrikwerte (d.h. diejenigen Übergangsmetrikwerte, die dem gerade in Abarbeitung befindlichen Butterfly zugeordnet sind) zugeführt werden. Hierfür ist die in Fig. 5 beispielhaft dargestellte Referenztabelle vorgesehen. Die Referenztabelle ordnet jedem Butterfly bzw. Butterfly-Index einen Zeiger zu, welcher auf den vom Rechenwerk RW1 bzw. RW2 für dieses Butterfly berechneten Übergangsmetrikwert α deutet. Beispielsweise kann die Referenztabelle den Ausgang oder den Speicherplatz (Adresse des jeweiligen Speichers M1-M8, M1'-M16') des verwendeten Rechenwerks RW1, RW2 angeben, von wo der zugehörige Übergangsmetrikwert a bezogen werden kann. Die Übergangsmetrikwerte zwischen Zuständen innerhalb eines Butterflies unterscheiden sich nur durch das Vorzeichen. Das für jeden Zustandsübergang innerhalb eines Butterflies spezifische Vorzeichen (α, -α, -α, α) wird vorzugsweise direkt in der ACS-Einheit berücksichtigt, so dass pro Butterfly nur ein Speicherzugriff erfolgen muss.

Fig. 5 zeigt einen möglichen Aufbau einer solchen Referenztabelle am Beispiel des EDGE-Standards. Da die Referenztabelle die "Zuordnungsvorschrift" zwischen dem Rechenwerk RW1, RW2 und der nachgeschalteten ACS-Einheit beinhaltet, kann auf diese Weise das Prozessieren des Viterbi-Trellis-Diagramms mittels der beiden gekoppelten Hardware-Einheiten (RW1/2 und ACS-Einheit) automatisiert werden.

Fig. 6 zeigt eine an die Fig. 1 angelehnte Darstellung einer erfindungsgemäßen Schaltungsanordnung nach dem zweiten Aspekt der Erfindung. Ein beispielsweise gemäß den Fig. 3 oder 4 realisiertes Hardware-Rechenwerk RW dient zur Berechnung von Übergangsmetrikwerten, welche über mehrere Ausgänge OUT (beispielsweise O1 bis O8 oder O1' bis O16') abrufbar sind.

Mittels z.B. eines Datenbusses B und einer Steuereinrichtung ST werden die über die Ausgänge OUT abrufbaren Übergangsmetrikwerte gemäß den Einträgen in der Referenztabelle der ACS-Einheit zugeleitet. Vorzugsweise handelt es sich bei der ACS-Einheit um ein ACS-Hardware-Rechenwerk, im folgenden mit dem Bezugszeichen ACS_RW bezeichnet. Das ACS-Hardware-Rechenwerk ACS_RW kann in vielfältiger Weise, z.B. gemäß dem bekannten Stand der Technik, ausgeführt sein.

In dem hier dargestellten Beispiel erfährt die Steuereinrichtung ST über eine Signalverbindung 6 den Index des im ACS-Hardware-Rechenwerk ACS_RW gerade zur Abarbeitung anstehenden Butterflies. Daraufhin wird gemäß der Referenztabelle derjenige Ausgang OUT des Hardware-Rechenwerks RW ermittelt, über welchen der zugehörige Übergangsmetrikwert α beziehbar ist. Die Steuereinrichtung ST steuert über eine Adressleitung 7 den Abruf des entsprechenden Übergangsmetrikwertes α, welcher daraufhin über den Datenbus B und eine Datenverbindung 8 dem ACS-Hardware-Rechenwerk ACS_RW zugeleitet wird.

Sowohl für verschiedene Standards als auch für verschiedene Faltungspolynome eines Kanalkodierers werden verschiedene Referenztabellen benötigt. Die Programmiermethodik der ACS-Einheit (bzw. des ACS-Hardware-Rechenwerks ACS_RW) durch die Verwendung unterschiedlicher Referenztabellen ist jedoch unabhängig von dem Standard, den verwendeten Faltungspolynomen und der Rückgrifftiefe des Kanalkodierers. Wie bereits erwähnt, erzwingen die Koderaten der unterschiedlichen Standards lediglich das Setzen von bestimmten Soft-Input-Werten (z.B. s3, s4) auf Null, so dass durch die Erfindung insgesamt ein Standard-unabhängiges Rechenverfahren in Hardware verwirklicht wird. Verschiedene Faltungspolynome und Rückgrifftiefen haben lediglich Einfluß auf den Inhalt der verschiedenen Referenztabellen (z.B. auf die Einträge in der Spalte "Ausgang").

Die benötigte Referenztabelle kann beispielsweise vor einer Gesprächsaufnahme von einem DSP berechnet werden. Damit haben auch die verwendeten Faltungspolynome und Rückgrifftiefen keinen Einfluß auf das Konzept der Hardware-Rechenwerke RW1, RW2, RW sowie deren Kopplung zu der ACS-Einheit.

Ein weiterer Vorteil der erfindungsgemäßen Lösung im Vergleich zu einer Berechnung der Übergangsmetrikwerte α in einem DSP ergibt sich aus der Tatsache, dass die Datenverbindung 1 einen wesentlich geringeren Bandbreitenbedarf als die Datenverbindung 2 in Fig. 1 aufweist. Da bei der Erfindung die Schnittstelle zwischen dem DSP und der Hardware-Unterstützung im Bereich der Datenverbindung 1 liegt, während bei einer Berechnung der Übergangsmetrikwerte mittels Firmware (d.h. im DSP) die entsprechende Schnittstelle im Bereich der Datenverbindung 2 angeordnet ist, kann bei der Erfindung eine DSP-Hardware-Schnittstelle mit wesentlich geringerer Bandbreite eingesetzt werden.

## Patentansprüche

1. Schaltungsanordnung für einen Viterbi-Decodierer, mit
- einem Hardware-Rechenwerk (RW1, RW2, RW) zur Berechnung von Übergangsmetrikwerten für einen Viterbi-Dekodierer, welches ausgelegt ist, einen Satz von n Soft-Input-Werten s1,..,sn entgegenzunehmen und daraufhin Übergangsmetrikwerte der Form i1·s1+..in·sn auszugeben, wobei n eine variable ganze Zahl mit n ≥ 2 ist und i1,..,in jeweils die Werte ±1 annehmen kann,
- einer Einheit (ACS, ACS_RW) zur Durchführung von ACS-Operationen und
- einem Steuermittel (ST) zur Steuerung des Zugriffs der Einheit (ACS, ACS_RW) zur Durchführung von ACS-Operationen auf die von dem Hardware-Rechenwerk (RW1, RW2, RW) berechneten Übergangsmetrikwerte,
**dadurch gekennzeichnet,**
- **dass** das Steuermittel (ST) ausgelegt ist, den Zugriff der Einheit (ACS, ACS_RW) zur Durchführung von ACS-Operationen gemäß einer Code-abhängigen Referenztabelle zu steuern, welche den Zustandsübergängen im Trellis-Diagramm die im Hardware-Rechenwerk (RW1, RW2, RW) berechneten Übergangsmetrikwerte zuweist, und
- **dass** die Schaltungsanordnung (RW, RW1, RW2; ACS, ACS_RW) für die Verwendung von mehreren unterschiedlichen Code-abhängigen Referenztabellen ausgelegt ist.

2. Schaltungsanordnung nach Anspruch 1,
**dadurch gekennzeichnet,**
- **dass** sich die Variabilität von n auf die Werte 2, 3 oder auf die Werte 2, 3, 4 erstreckt.

3. Schaltungsanordnung nach einem der Ansprüche 1 oder 2,
**dadurch gekennzeichnet,**
- **dass** das Hardware-Rechenwerk (RW1, RW2) eine Mehrzahl von parallel angeordneten Addierern (A1-4; A1'-8') sowie Negierern (N1-8; N1'-20') umfasst, und dass jeder Addierer (A1-4; A1'-8') nmax Eingänge aufweist, wobei nmax der maximale Wert ist, welchen n annehmen kann.

4. Schaltungsanordnung nach Anspruch 3,
**dadurch gekennzeichnet,**
- **dass** das Hardware-Rechenwerk (RW1, RW2) eine Anzahl von 2^{nmax-1} Addierern (A1-4; A1'-8') aufweist, und
- **dass** jedem Ausgang eines Addierers (A1-4; A1'-8') ein erster Negierer (N5-8; N13'-20') nachgeschaltet ist.

5. Schaltungsanordnung nach einem der Ansprüche 3 oder 4,
**dadurch gekennzeichnet,**
- **dass** vier Addierer (A1-4) mit jeweils drei Eingängen vorgesehen sind.

6. Schaltungsanordnung nach Anspruch 5,
**dadurch gekennzeichnet,**
- **dass** bestimmten Eingängen der Addierer (A1-4) zweite Negierer (N1-4) vorgeordnet sind, derart, dass jeweils diejenigen zwei Addierereingänge der vier Addierer (A1-4), welche den Soft-Input-Werten s1 und s2 zugeordnet sind, bei einem Addierer (A1) beide nicht negiert, bei zwei Addierern (A2, A3) wechselweise einer negiert und bei einem vierten Addierer (A4) beide negiert sind.

7. Schaltungsanordnung nach einem der Ansprüche 3 oder 4,
**dadurch gekennzeichnet,**
- **dass** acht Addierer (A1'-8') mit jeweils vier Eingängen vorgesehen sind.

8. Schaltungsanordnung nach Anspruch 7,
**dadurch gekennzeichnet,**
- **dass** bestimmten Eingängen der Addierer (A1'-8') zweite Negierer (N1'-N12') vorgeordnet sind, derart, dass jeweils diejenigen drei Addierereingänge der acht Addierer (A1'-8'), welche den Soft-Input-Werten s1 s2 und s3 zugeordnet sind, bei einem Addierer (A1') sämtlich nicht negiert, bei drei Addierern (A2', A3', A5') wechselweise jeweils einer negiert, bei drei Addierern (A4', A6', A7') wechselweise jeweils zwei negiert und bei einem Addierer (A8') sämtliche negiert sind.

9. Schaltungsanordnung nach einem der Ansprüche 1 bis 8,
**dadurch gekennzeichnet,**
- **dass** die Referenztabelle allen Zustandsübergängen innerhalb eines Butterflies im Trellis-Diagramm genau einen Übergangsmetrikwert (α) zuweist.

10. Schaltungsanordnung nach einem der Ansprüche 1 bis 9,
**gekennzeichnet durch**
- einen digitalen Signalprozessor, welcher zur Programmierung der Referenztabelle ausgelegt ist.

## Claims

1. Circuit arrangement for a Viterbi decoder, having
- a hardware arithmetic and logic unit (RW1, RW2, RW) for calculating transition metric values for a Viterbi decoder, which (hardware arithmetic and logic unit) is designed to receive a set of n soft input values s1,...,sn and then to output transition metric values in the form i1·s1+..+in·sn, where n is a variable integer and n ≥ 2, and i1,...,in can respectively assume the values ±1,
- a unit (ACS, ACS_RW) for performing ACS operations, and
- a control means (ST) for controlling the access by the unit (ACS, ACS_RW) for the purpose of performing ACS operations on the transition metric values calculated by the hardware arithmetic and logic unit (RW1, RW2, RW),
**characterized**
- **in that** the control means (ST) is designed to control the access by the unit (ACS, ACS_RW) for the purpose of performing ACS operations on the basis of a code-dependent reference table which assigns the transition metric values calculated in the hardware arithmetic and logic unit (RW1, RW2, RW) to the state transitions in the trellis diagram, and
- **in that** the circuit arrangement (RW, RW1, RW2; ACS, ACS_RW) is designed for the use of a plurality of different code-dependent reference tables.

2. Circuit arrangement according to Claim 1,
**characterized**
- **in that** the variability of n extends to the values 2, 3 or to the values 2, 3, 4.

3. Circuit arrangement according to either of Claims 1 and 2,
**characterized**
- **in that** the hardware arithmetic and logic unit (RW1, RW2) comprises a plurality of adders (A1-4; A1'-8') and negators (N1-8; N1'-20') arranged in parallel, and in that each adder (A1-4; A1'-8') has nmax inputs, with nmax being the maximum value which n can assume.

4. Circuit arrangement according to Claim 3,
**characterized**
- **in that** the hardware arithmetic and logic unit (RW1, RW2) has a number of 2^{nmax-1} adders (A1-4; A1'-8'), and
- **in that** each output on an adder (A1-4; A1'-8') has a first negator (N5-8; N13'-20') connected downstream of it.

5. Circuit arrangement according to either of Claims 3 and 4,
**characterized**
- **in that** four adders (A1-4) having three inputs each are provided.

6. Circuit arrangement according to Claim 5,
**characterized**
- **in that** particular inputs on the adders (A1-4) are preceded by second negators (N1-4) such that, of those two respective adder inputs on the four adders (A1-4) which are associated with the soft input values s1 and s2, both are unnegated in the case of one adder (A1), one is negated alternately in the case of two adders (A2, A3), and both are negated in the case of a fourth adder (A4).

7. Circuit arrangement according to either of Claims 3 and 4,
**characterized**
- **in that** eight adders (A1'-8') with four inputs each are provided.

8. Circuit arrangement according to Claim 7,
**characterized**
- **in that** particular inputs on the adders (A1'-8') are preceded by second negators (N1'-N12') such that, of those three respective adder inputs on the eight adders (A1'-8') which are associated with the soft input values s1, s2 and s3, all are unnegated in the case of one adder (A1'), one is respectively negated alternately in the case of three adders (A2', A3', A5'), two are respectively negated alternately in the case of three adders (A4', A6', A7'), and all are negated in the case of one adder (A8').

9. The circuit arrangement according to one of Claims 1 to 8,
**characterized**
- **in that** the reference table assigns precisely one transition metric value (α) to all of the state transitions within a butterfly in the trellis diagram.

10. The circuit arrangement according to one of Claims 1 to 9,
**characterized by**
- a digital signal processor which is designed to program the reference table.

## Revendications

1. Montage pour un décodeur de Viterbi, comportant
- un calculateur (RW1, RW2, RW) en matériel pour calculer des valeurs métriques de transition pour un décodeur de Viterbi, qui est conçu pour recevoir un ensemble de n valeur s1, ..., sn Soft-Input et pour émettre ensuite des valeurs métriques de transition de la forme i1 s1+..+in.sn, n étant un nombre entier variable avec n ≥ à 2 et i1,...,in pouvant prendre respectivement les valeurs ±1,
- une unité (ACS, ACS_RW) pour la mise en oeuvre d'opérations ACS et
- un moyen (ST) de commande pour commander l'accès de l'unité (ACS, ACS_RW) pour effectuer des opérations ACS sur les valeurs métriques de transition calculées par le calculateur (RW1, RW2, RW) en matériel,
**caractérisé en ce que**,
- le moyen (ST) de commande est conçu pour commander l'accès de l'unité (ACS, ACS_RW) pour effectuer des opérations ACS suivant une table de référence dépendante d'un code, table qui affecte aux transitions d'état dans le diagramme de Trellis les valeurs métriques de transitions calculées dans le calculateur (RW1, RW2, RW) en matériel, et
- le montage (RW, RW1, RW2; ACS, ACS_RW) est conçu pour l'utilisation de plusieurs tables de référence différentes dépendantes d'un code.

2. Montage suivant la revendication 1,
**caractérisé en ce que**,
- la variabilité de n peut être étendue aux valeurs 2, 3 ou valeurs 2, 3, 4.

3. Montage suivant l'une des revendications 1 ou 2,
**caractérisé en ce que**,
- le calculateur (RW1, RW2) en matériel comprend une pluralité d'additionneurs (A1-4; A1'-8') montés en parallèles, ainsi que des inverseurs (N1-8; N1'-20') et **en ce que** chaque additionneur (A1-4; A1'-8') comportent nmax entrées, nmax étant la valeur maximum que n peut prendre.

4. Montage suivant la revendication 3,
**caractérisé en ce que**,
- le calculateur (RW1, RW2) en matériel comporte un nombre de 2^{nmax-1} additionneurs (A1-4; A1'-8'), et
- un premier inverseur (N5-8; N13'-20') est monté en aval de chaque sortie d'un additionneur (A1-4; A1'-8').

5. Montage suivant l'une des revendications 3 ou 4,
**caractérisé en ce que**,
- il est prévu quatre additionneurs (A1-4) ayant chacun trois entrées.

6. Montage suivant la revendication 5,
**caractérisé en ce que**,
- il est monté en amont d'entrées déterminées des additionneurs (A1-4) des deuxièmes inverseurs (N1-4) de telle manière que respectivement les deux entrées des quatre additionneurs (A1-4) qui sont associés aux valeurs s1 et s2 Soft-Input ne sont toutes deux pas inversées pour un additionneur (A1), sont inversées alternativement pour deux additionneurs (A2, A3) et sont toutes deux inversées pour un quatrième additionneur (A4).

7. Montage suivant l'une des revendications 3 ou 4,
**caractérisé en ce que**,
- il est prévu huit additionneurs (A1'-8') comportant chacun quatre entrées.

8. Montage suivant la revendication 7,
**caractérisé en ce que**,
- des deuxièmes inverseurs (N1' -N12') sont montés en amont d'entrées déterminées des additionneurs (A1'-8') de telle manière que respectivement les trois entrées des huit additionneurs (A1'-8') qui sont associées aux valeurs s1 s2 et s3 Soft-Input ne sont toutes pas inversées pour un premier additionneur (A1'), sont inversées à tour de rôle une à une pour trois additionneurs (A2', A3', A5'), sont inversées alternativement deux à deux pour trois additionneurs (A4', A6', A7') et sont toutes inversées pour un additionneur (A8').

9. Montage suivant l'une des revendications 1 à 8,
**caractérisé en ce que**,
- la table de référence affecte exactement une valeur (α ) métrique de transition à toutes les transitions d'état à l'intérieur d'un papillon dans le diagramme de Trellis.

10. Montage suivant l'une des revendications 1 à 9,
**caractérisé par**,
- un processeur de signaux numériques, qui est conçu pour la programmation de la table de référence.
